Europäisches Patentamt

(19) European Patent Office

Office européen des brevets

(11) **EP 0 805 484 A1**

(12) **EUROPEAN PATENT APPLICATION**
published in accordance with Art. 158(3) EPC

(43) Date of publication:
05.11.1997 Bulletin 1997/45

(51) Int. Cl.$^6$: **H01L 21/304**

(21) Application number: 96900431.6

(86) International application number:
PCT/JP96/00028

(22) Date of filing: 11.01.1996

(87) International publication number:
WO 96/21942 (18.07.1996 Gazette 1996/33)

(84) Designated Contracting States:
DE FR GB IT

(30) Priority: 13.01.1995 JP 3883/95

(71) Applicant:
DAIKIN INDUSTRIES, LIMITED
Osaka-shi Osaka 530 (JP)

(72) Inventors:
• ITANO, Mitsushi,
Yodogawa Works of Daikin Ind Ltd.
Settsu-shi, Osaka 566 (JP)

• KEZUKA, Takehiko,
Yodogawa Works of Daikin Ind Ltd
Settsu-shi, Osaka 566 (JP)
• SUYAMA, Makoto,
Yodogawa Works of Daikin Ind. Ltd.
Settsu-shi, Osaka 566 (JP)

(74) Representative:
Hansen, Bernd, Dr. Dipl.-Chem. et al
Hoffmann Eitle,
Patent- und Rechtsanwälte,
Arabellastrasse 4
81925 München (DE)

(54) **METHOD OF CLEANING SUBSTRATES**

(57) In a method for removing particles from a substrate, in particular a silicon wafer substrate, comprising the steps of cleaning the substrate with ammonia and aqueous hydrogen peroxide, rinsing the substrate with ultra pure water, the substrate with fluorohydric acid, and rinsing the substrate with ultra pure water, an anionic surfactant is added to fluorohydric acid, and optionally to a mixture containing ammonia and aqueous hydrogen peroxide. This method increases a particle-removing rate considerably, since the particles which have been removed from the substrate in the cleaning step using the mixture containing ammonia and aqueous hydrogen peroxide are not readsorbed on the substrate in the cleaning step using hydrogen fluoride.

Fig. 3

EP 0 805 484 A1

## Description

FIELD OF THE INVENTION

The present invention relates to a method for cleaning a substrate. In particular, the present invention relates to a method for cleaning a substrate made of a metal, an alloy, a ceramic and the like, which is used in the production of electronic materials, magnetic materials, optical materials, ceramics and the like, by removing particles deposited on the surface of the substrate. The present invention relates particularly to a method for cleaning a silicon water substrate in the production of semiconductors, by removing particles deposited on the surface of the water substrate.

BACKGROUND ART

The degree of integration of semiconductor integrated circuits such as LSIs which are produced by forming circuits on semiconductor substrates (water) made of silicon single crystal has increased greatly in recent years, and also the line width of the circuits becomes thinner and thinner. Accordingly, fine particles remained on the substrates deteriorate the quality and yield of products, as the fineness of the circuits increase.

A method for cleaning particles deposited on a water is described in RCA Review, 31 (1970), pages 187-206. This method comprises heating a mixture of aqueous ammonia and aqueous hydrogen peroxide, and a mixture of an acid such as hydrochloric acid and aqueous hydrogen peroxide to about 80°C, and dipping a wafer in the heated mixtures successively (RCA cleaning). Of these two mixtures containing hydrogen peroxide, one containing ammonia and hydrogen peroxide is used to remove particles deposited on the surface of the water substrate, while one containing hydrochloric acid and hydrogen peroxide is used to remove metals deposited on the surface of the water substrate.

In the RCA cleaning, the water should be further treated to remove a native oxide by dipping it in hydrofluoric acid (dilute hydrofluoric acid) in some production methods, since the native oxide remains on the surface of the cleaned silicon substrate. That is, in many production processes of integrated circuits, the wafers are cleaned by combining the RCA cleaning and treatment with hydrofluoric acid as follows:

(1) Dip cleaning of wafers in a mixture of ammonia-aqueous hydrogen peroxide-ultra pure water
Usually, this cleaning is carried out at a cleaning temperature of about 80°C for about 10 minutes. In general, a mixture of 29 wt. % aqueous ammonia, 30 w.t % aqueous hydrogen peroxide, and ultra pure water (volume ratio of 1:1:5) is used, although this ratio may be changed.
(2) Rinsing of the mixture with ultra pure water
This rinsing is carried out at room temperature (about 25°C) for about 5 to 10 minutes, or at an elevated temperature of between about 80 and 90°C for about 5 to 10 minutes.
(3) Dip cleaning of wafers in hydrofluoric acid
This cleaning is carried out using dilute hydrofluoric acid having a concentration of about 0.5 % at a temperature of about 25°C for about one minute.
(4) Rinsing of hydrofluoric acid with ultra pure water
This rinsing is carried out at a temperature of about 25°C for about 5 to 10 minutes.
(5) Dip cleaning of wafers in a mixture of hydrochloric acid and aqueous hydrogen peroxide
This cleaning is carried out at a temperature of about 80°C for about 10 minutes. In general, a mixture of 36 wt. % hydrochloric acid, 30 wt. % aqueous hydrogen peroxide, and ultra pure water (volume ratio of 1:1:6) is used, although this ratio may be changed.
(6) Rinsing of the mixture with ultra pure water
This rinsing is carried out at room temperature (about 25°C) for about 5 to 10 minutes, or at an elevated temperature of between about 80 and 90°C for about 5 to 10 minutes.
(7) Dip cleaning of wafers in hydrofluoric acid
This cleaning is carried out using dilute hydrofluoric acid having a concentration of about 0.5 % at a temperature of about 25°C for about one minute.
(8) Rinsing of hydrofluoric acid with ultra pure water
This rinsing is carried out at a temperature of about 25°C for about 5 to 10 minutes.

In the above RCA cleaning, the particles deposited on the wafer substrate are substantially removed by the cleaning process with ammonia and aqueous hydrogen peroxide in the steps (1) through (4).

That is, the particles deposited on the surface of the wafer substrate are removed by the cleaning with the mixture of ammonia, aqueous hydrogen peroxide and ultra pure water at about 80°C, the rinsing with ultra pure water, the cleaning with dilute hydrofluoric acid, and the subsequent rinsing with ultra pure water, in the RCA cleaning steps.

However, when the mixture of ammonia, aqueous hydrogen peroxide and ultra pure water is heated to about 80°C, the vapor pressure of ammonia increases, and furthermore hydrogen peroxide quickly decomposes. Thus, the composition of the mixture changes in a short time. As a result, the life of the mixture is shortened, and the mixture should be replaced with a fresh mixture frequently.

The cleaning of wafers is carried out at a wet station in a clean room while evacuating the vapors of the reagents. However, since the temperature is as high as 80°C, the large volume of the vapors should be evacuated. Consequently, a large amount of fresh air should be supplied in the clean room, and thus an amount of consumed electric power for operating the clean room increases. Accordingly, it is highly desired to develop a low temperature cleaning method which has a good removing ability to remove the deposited particles from the wafer, for the cleaning step using ammonia and aqueous hydrogen peroxide.

SUMMARY OF THE INVENTION

An object of the present invention is to provide a cleaning process using ammonia and aqueous hydrogen peroxide which has a good ability to remove deposited particles from wafers at room temperature (about 25°C).

Accordingly, the present invention provides a method for cleaning a substrate by the removal of deposited particles from the substrate, comprising the steps of:

(1) cleaning the substrate with ammonia and aqueous hydrogen peroxide,
(2) rinsing the substrate with ultra pure water,
(3) cleaning the substrate with hydrofluoric acid containing an anionic surfactant,
and
(4) rinsing the substrate with ultra pure water.

In a preferable embodiment, an anionic surfactant may be added to a mixture containing ammonia and aqueous hydrogen peroxide.

BRIEF DESCRIPTION OF THE DRAWINGS

Fig. 1 is a graph showing potential energies in a treating liquid used in conventional cleaning methods.

Fig. 2 is a graph showing potential energies in a treating liquid used in the cleaning method according to the present invention.

Fig. 3 is a graph showing zeta-potentials of polystyrene latex particles, silicon particles, $SiO_2$ particles, and $Si_3N_4$ particles.

DETAILED DESCRIPTION OF THE INVENTION

It is well known to add a surfactant to a general cleaning liquid (see, for example, JP-A-6-41770 entitled "Method for Treating Silicon Wafer Surface", JP-A-6-84866 entitled "Method for Preventing Deposition of Foreign Materials", and JP-A-6-232107 entitled "Agent for Treating Finely Processed Surface").

The present invention is based on a finding of an unexpected effect that deposited particles can be effectively removed from wafer substrates even at room temperature, when an anionic surfactant is added to dilute hydrofluoric acid which is used after the cleaning of the wafer substrate with a mixture containing ammonia and aqueous hydrogen peroxide in the course of the removal of deposited particles from the wafer substrate. It is also found that the addition of an anionic surfactant to a mixture containing ammonia and aqueous hydrogen peroxide increases the ability of this mixture to remove the particles at room temperature.

To remove the particles deposited on the substrate by the cleaning method of the present invention, firstly, the wafer is dip cleaned with a mixture containing ammonia and aqueous hydrogen peroxide at a temperature around room temperature (15 to 30°C) requiring no heating for about 10 minutes, and then the wafer is rinsed with ultra pure water to remove the mixture from the wafer.

A composition of the mixture comprising ammonia, aqueous hydrogen peroxide and ultra pure water may be the same as conventional compositions.

Next, the wafer is dip cleaned with hydrofluoric acid (diluted hydrofluoric acid with a concentration of between about 0.1 and 5 wt. %) to which an anionic surfactant has been added, to remove a native oxide formed on the wafer. Finally, the wafer is rinsed with ultra pure water for about 5 minutes to remove the mixture.

Preferable examples of the anionic surfactant used in the present invention are carboxylic acid type, sulfonic acid type and sulfate type anionic surfactants having a hydrophilic group such as groups of the formulas: $-COOH$, $-SO_3H$ and $-OSO_3H$ and their metal salts, ammonium salts, and primary, secondary and tertiary amine salts. These anionic surfactants may be used independently or in admixture of at least two of them.

Specific examples of the anionic surfactants are

CF₃(CF₂)ₙCOOH, (CF₃)₂CF(CF₂)ₙCOOH, HCF₂(CF₂)ₙCOOH, CF₃(CF₂)ₙ(CH₂)ₘCOOH, CF₃(CF₂)ₙCF=CH(CH₂)ₘCOOH, Cl(CF₂CFCl)ₚCF₂COOH in which n is a number of 2 to 17, m is a number of 1 to 2, and p is a number of 1 to 9, and their metal salts, ammonium salts, and primary, secondary and tertiary amine salts;

and

$C_nH_{2n+1}SO_3H$, $C_nH_{2n+1}O(CH_2CH_2O)_mSO_3H$, $C_nH_{2n+1}\text{-Ph-}SO_3H$, $C_nH_{2n+1}\text{-Ph}(SO_3H)\text{-O-Ph-}SO_3H$ in which Ph is a phenylene group, n is a number of 5 to 20, and m is a number of 0 to 20, and their metal salts, ammonium salts, and primary, secondary and tertiary amine salts.

Typical examples of the sulfonic acid type ones are $C_{12}H_{25}O(CH_2CH_2O)_2SO_3H$, $C_9H_{19}PhO(CH_2CH_2O)_4SO_3H$, $C_{12}H_{24}O(CH_2CH_2O)_4SO_3H$, $C_6F_{11}PhSO_3H$, $C_9F_{17}OPhSO_3H$, $RCH=CH(CH_2)_nSO_3H$ in which R is a hydrocarbon group a hydrogen atom of which may be substituted with a fluorine atom, $C_{12}H_{25}OSO_3H$, $C_{12}H_{25}\text{-Ph}(SO_3H)\text{-O-Ph-}SO_3H$, and their metal salts, ammonium salts, and primary, secondary and tertiary amine salts.

The concentration of the anionic surfactant is at least 0.1 ppm, preferably between 0.2 and 3000 ppm, more preferably between 0.5 and 1000 ppm, based on the amount of hydrofluoric acid or the mixture of ammonia and aqueous hydrogen peroxide (and optionally ultra pure water).

Zeta-potentials of the substrate and foreign particles will explain a reason for the increase of the ability to remove the particle of the cleaning method using the ammonia-aqueous hydrogen peroxide mixture at room temperature around 25°C, by the addition of the anionic surfactant to dilute hydrofluoric acid.

A zeta-potential on a surface of a solid in an alkaline cleaning liquid is usually negative (see, for example, Fumio Kitahara, "Interfacial Electrodynamic Phenomena" (KAIMEN DODEN GENSHO)). Since the ammonia-aqueous hydrogen peroxide cleaning liquid is alkaline, the zeta-potential of particles deposited on the surface of the wafer substrate is contemplated to be negative. Thus, there is an electrostatic repulsion force between the particles and the surface of the wafer substrate.

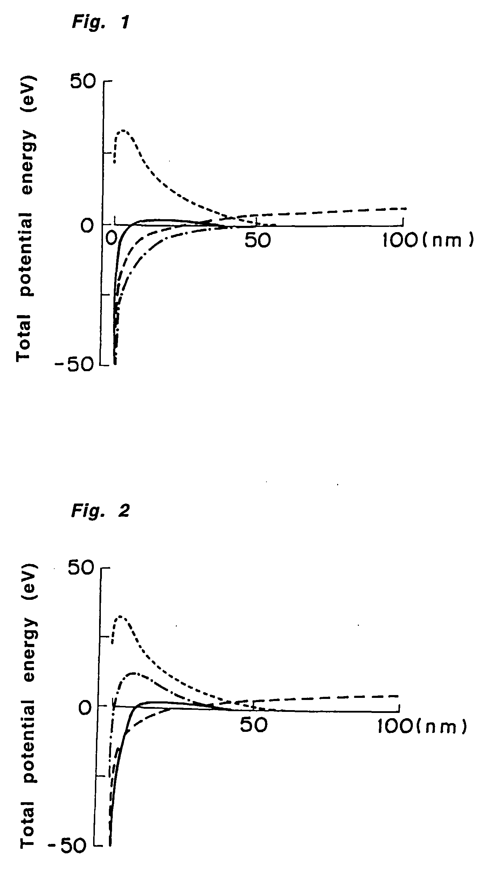

The dot line in Fig. 1 shows the potential energy which is generated between polystyrene latex particles (PSL) and a native oxide ($SiO_2$) in a mixture of ammonia, aqueous hydrogen peroxide and ultra pure water in a volume ratio of 1:1:5.

In the figures, a positive value means a repulsive force, while a negative value means an attractive force.

Zeta-potentials of the polystyrene latex particles and the native oxide surface ($SiO_2$ particles being used as substitutes for the native oxide surface in the measurement of the zeta-potential) were measured in a liquid having pH of 10.7, which is the same pH as that of the above mixture having the volume ratio of 1:1:5, using a zeta-potential static charge meter based on an electrophoretic light-scattering method (ELS-800 manufactured by OTSUKA ELECTRONIC). The zeta-potential of the polystyrene latex particles was -60 mV, and that of the native oxide surface was -60 mV.

It is contemplated that the particles leave the surface of the wafer substrate in the ammonia-aqueous hydrogen peroxide cleaning liquid, since the zeta-potentials of the surface of the wafer substrate and the particles are both negative, and thus the electrostatic repulsive force is generated between them.

However, as shown in Fig. 1, the electrostatic repulsive force reaches only in a short distance of about 50 nm. Therefore, the removed particles still float near the surface of the wafer substrate. In the cleaning method using the ammonia-aqueous hydrogen peroxide mixture, the particles which are present near the surface of the wafer substrate are transferred together with the cleaning liquid into the rinsing step using ultra pure water when the wafer is transferred from the cleaning step to the subsequent rinsing step, since the native oxide is formed on the silicon substrate.

Zeta-potentials of the polystyrene latex particles and the native oxide surface ($SiO_2$ particles being used as substitutes for the native oxide surface in the measurement of the zeta-potential) were measured in ultra pure water, and -20 mV and -60 mV, respectively. Thus, the electrostatic repulsive force is generated between the polystyrene latex particles and the native oxide surface in ultra pure water.

The broken line in Fig. 1 shows the potential energy which is generated between polystyrene latex particles (PSL) and a native oxide in ultra pure water. In this case, the ammonia-aqueous hydrogen peroxide mixture and the particles therein, which are both present on the surface of the wafer substrate and thus transferred into the rinsing step, are gradually rinsed, and the particles which are floating near the surface of the wafer substrate gradually leave the wafer substrate by rinsing. However, the particles may not be readily washed off in a rinsing time of between 5 and 10 minutes. Thus, ultra pure water adhering to the surface of the wafer surface and also the particles therein are transferred to the cleaning step using dilute hydrofluoric acid, when the wafer substrate is transferred from the previous rinsing step to the cleaning step.

Zeta-potentials of the polystyrene latex particles and the native oxide surface ($SiO_2$ particles being used as substitutes for the native oxide surface in the measurement of the zeta-potential) were measured in hydrochloric acid having pH of 3.3 which is the same pH as that of 0.5 % hydrofluoric acid (since a zeta-potential cannot be measured in dilute hydrofluoric acid), and +40 mV and +10 mV, respectively. The zeta-potential of a silicon surface from which the native oxide had been removed (Si particles being used as substitutes for the silicon surface in the measurement of the zeta-potential) was -20 mV. Thus, the electrostatic repulsive force remains between the particles and the native oxide along the potential curve indicated by the solid line in Fig. 1, when the native oxide remains in the cleaning step using dilute hydrofluoric acid.

However, once the native oxide is removed with dilute hydrofluoric acid and the silicon surface is exposed, the electrostatic repulsive force disappears between the particles and the silicon surface, as shown by the alternative long and short dash line in Fig. 1. As a result, the particles, which are contained in ultra pure water adhering to the surface of the wafer substrate, are readsorbed to the surface, when the silicon surface is exposed.

As explained above, the removal of the deposited particles from the surface of the wafer substrate cannot be accomplished by cleaning, if the particles, which have been removed from the surface of the wafer substrate by cleaning with the ammonia-aqueous hydrogen peroxide mixture, are readsorbed during the cleaning step with dilute hydrofluoric acid.

Fig. 2 shows potential energy curves when the anionic surfactant is added to dilute hydrofluoric acid according to the present invention.

Zeta-potentials of the polystyrene latex particles, the native oxide surface ($SiO_2$ particles being used as substitutes for the native oxide surface in the measurement of the zeta-potential) and the silicon surface (Si particles being used as substitutes for the silicon surface in the measurement of the zeta-potential) were measured in hydrochloric acid having pH of 3.3 which is the same pH as that of 0.5 % hydrofluoric acid (since a zeta-potential cannot be measured in dilute hydrofluoric acid) and containing 10 ppm of the anionic surfactant $C_9F17$-O-p-Ph-$SO_3H$ (p-Ph = para-phenylene group), and were -70 mV, -10 mV and -30 mV, respectively.

As indicated by the solid line and alternative long and short dash line in Fig. 2, the electrostatic repulsive force is generated between the particles and the native oxide surface, and also between the particles and the silicon surface. As a result, the particles which are transferred, together with ultra pure water adhering to the surface of the water substrate, into the cleaning step using dilute hydrofluoric acid are not readsorbed to the substrate surface.

According to the cleaning method of the present invention, the particles are removed from the surface of the wafer substrate by cleaning with the ammonia-aqueous hydrogen peroxide mixture, and the removed particles are not readsorbed to the substrate surface in the subsequent cleaning steps. Therefore, the particle-removing rate after all the steps of the method of the present invention is very high. As a result, the good particle-removing effect is attained by the cleaning process using the ammonia-aqueous hydrogen peroxide mixture even at room temperature.

The above descriptions show the change of zeta-potentials and the potential energy curves in the cleaning process using the ammonia-aqueous hydrogen peroxide mixture, in relation to the polystyrene latex particles. Zeta-potentials of other particles exhibit substantially the same change as that of the polystyrene latex particles according to pH of the cleaning liquid.

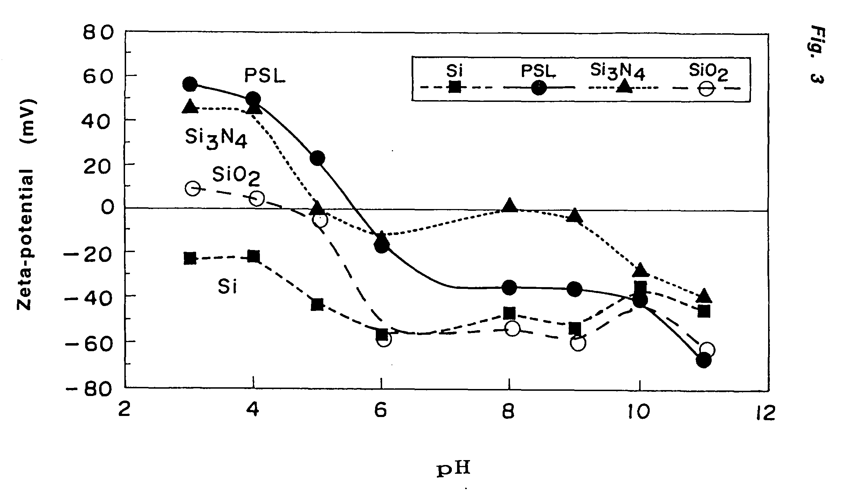

Fig. 3 shows zeta-potentials of $SiO_2$, $Si_3N_4$, polystyrene latex particles (PLS), and silicon (Si) particles measured at various pH values of cleaning liquids.

In the acidic liquid, all the materials except the silicon particles have the positive zeta-potentials, while in the alkaline liquid, all the materials have the negative zeta-potentials.

In most cases, particles present in the production methods of semiconductors are those of Si, $SiO_2$, $Si_3N_4$, and the like, which are used as raw materials. $SiO_2$ particles and $Si_3N_4$ particles behave in a similar way as the polystyrene latex particles, since the former particles have close zeta-potentials to that of the latter particles. The silicon particles are not readsorbed, since their zeta-potential is negative in dilute hydrofluoric acid.

EXAMPLES

The present invention will be illustrated by the following examples.

Example 1

Polystyrene latex particles having a diameter of 0.6 $\mu$m were used as model particles to examine the cleaning effect of an aqueous mixture of ammonia and hydrogen peroxide.

About 5000 polystyrene latex particles were adhered to the surface of a 4 inch silicon wafer (4 inch CZ-N (100)). The silicon wafer was cleaned by the process using the ammonia-hydrogen peroxide mixture, and an ability to remove particles was measured after the whole steps.

Table 1 shows the particle-removing rates at a cleaning temperature of 80°C and 25°C when a mixture of ammonia, aqueous hydrogen peroxide and ultra pure water in a volume ratio of 1:1:5 was used as a typical composition.

The cleaning process conditions were as follows:

(1) Dip cleaning in the mixture of ammonia, aqueous hydrogen peroxide and ultra pure water: 10 minutes;
(2) Rinsing with ultra pure water: 5 minutes;
(3) Dip cleaning in 0.5 wt. % hydrofluoric acid: 1 minute;
(4) Rinsing with ultra pure water: 5 minutes.

The aqueous ammonia was 29 wt. % one, and the aqueous hydrogen peroxide was 30 wt. % one. 10 ppm of the anionic surfactant $C_9F17$-O-p-Ph-$SO_3H$ was added to dilute hydrofluoric acid.

Five wafer substrates were stored in a wafer cassette, and transferred by hand through a dip cleaning bath for cleaning with ammonia and aqueous hydrogen peroxide, a rinsing bath containing ultra pure water, a dip cleaning bath for cleaning with dilute hydrofluoric acid, and a rinsing bath containing ultra pure water.

The number of the PSL particles adhered to the wafer substrate was measured using a laser surface inspecting apparatus LS-5000 (manufactured by HITACHI ELECTRONIC ENGINEERING) before and after the cleaning process. A particle-removing rate was calculated according to the following formula:

Particle-removing rate = [(the number of particles before cleaning - the number of particles after cleaning) x 100]/(the number of particles before cleaning)

Table 1

| Cleaning temp. | Surfactant | | No. of particles adhered to wafers (No./wafer) | | Particle-removing rate (%) |
|---|---|---|---|---|---|
| | Structure | Concentration | Before cleaning | After cleaning | |
| 80°C | $C_9F_{17}$-O-p-Ph-$SO_3H$ | 10 ppm | 5310 | 150 | 97.2 |
| 25°C | $C_9F_{17}$-O-p-Ph-$SO_3H$ | 10 ppm | 5430 | 240 | 95.6 |

Example 2

Wafers were cleaned in the same manner as in Example 1 except that kinds and concentrations of surfactants added to dilute hydrofluoric acid were changed as shown in Table 2, and the cleaning temperature was 25°C.

For comparison, the results obtained by adding no surfactant, or a cationic or nonionic surfactant to dilute hydrofluoric acid are also shown in Table 2.

Table 2

| Surfactant | | No. of particles adhered to wafers (No./wafer) | | Particle-removing rate (%) |
|---|---|---|---|---|
| Structure | Concentration | Before cleaning | After cleaning | |
| (None) | 0 ppm | 5920 | 1180 | 80.1 |
| $C_9F17$-O-p-Ph-$SO_3H$ (anionic) | 1 ppm | 5270 | 270 | 94.9 |
| | 10 ppm | 5430 | 240 | 95.6 |
| $C_{12}H_{25}$-Ph($SO_3H$)-O-Ph($SO_3H$) (anionic) | 10 ppm | 4800 | 280 | 94.2 |
| $C_7F_{15}COONH_4$ (anionic) | 200 pm | 4920 | 430 | 91.3 |
| $C_{12}H_{25}N(CH_2CH_2OH)_2$ (cationic) | 200 ppm | 3630 | 960 | 73.6 |
| $C_8H_{17}NH_2$ (cationic) | 200 ppm | 4210 | 1140 | 72.9 |
| $C_{12}H_{25}O(CH_2CH_2O)_9H$ (nonionic) | 200 ppm | 3200 | 520 | 83.6 |

Example 3

Wafers were cleaned in the same manner as in Example 1 except that a volume ratio of ammonia, aqueous hydro-

6

gen peroxide and ultra pure water was changed to 0.5:1:5 ($NH_4OH:H_2O_2:H_2O$), and the cleaning temperature was 25°C. The results are shown in Table 3.

For comparison, the results obtained by adding no surfactant or by adding a cationic or nonionic surfactant to dilute hydrofluoric acid are also shown in Table 3.

Table 3

| Surfactant | | No. of particles adhered to wafers (No./wafer) | | Particle-removing rate (%) |
|---|---|---|---|---|
| Structure | Concentration | Before cleaning | After cleaning | |
| (None) | 0 ppm | 7610 | 4330 | 43.1 |
| $C_9F_{17}$-O-p-Ph-$SO_3H$ | 10 ppm | 5430 | 500 | 90.8 |
| $C_{12}H_{25}N(CH_2CH_2OH)_2$ | 200 ppm | 7530 | 4040 | 46.3 |
| $C_{12}H_{25}O(CH_2CH_2O)_9H$ | 200 ppm | 4570 | 1770 | 61.3 |

Example 4

Wafers were cleaned in the same manner as in Example 1 except that a volume ratio of ammonia, aqueous hydrogen peroxide and ultra pure water was changed to 5:1:5 ($NH_4OH:H_2O_2:H_2O$), and the cleaning temperature was 25°C. The results are shown in Table 4.

For comparison, the results obtained by adding no surfactant, or a cationic or nonionic surfactant to dilute hydrofluoric acid are also shown in Table 4.

Table 4

| Surfactant | | No. of particles adhered to wafers (No./wafer) | | Particle-removing rate (%) |
|---|---|---|---|---|
| Structure | Concentration | Before cleaning | After cleaning | |
| (None) | 0 ppm | 8690 | 3480 | 60.0 |
| $C_9F_{17}$-O-p-Ph-$SO_3H$ | 10 ppm | 5640 | 190 | 96.6 |
| $C_{12}H_{25}N(CH_2CH_2OH)_2$ | 200 ppm | 9080 | 3760 | 58.6 |
| $C_{12}H_{25}O(CH_2CH_2O)_9H$ | 200 ppm | 8140 | 1930 | 76.3 |

Example 5

Wafers were cleaned in the same manner as in Example 1 except that a volume ratio of ammonia, aqueous hydrogen peroxide and ultra pure water was changed to X:1:5 ($NH_4OH:H_2O_2:H_2O$) (X being shown in Table 5), and the cleaning temperature was 25°C. The results are shown in Table 5.

Table 5

| Mixing ratio (NH$_4$OH: H$_2$O$_2$:H$_2$O) | Surfactant | | No. of particles adhered to wafers (No./wafer) | | Particle-removing rate (%) |
|---|---|---|---|---|---|
| | Structure | Concentration | Before cleaning | After cleaning | |
| 10$^{-3}$:1:5 | C$_9$F$_{17}$-O-p-Ph-SO$_3$H | 10 ppm | 5660 | 5110 | 9.7 |
| 0.005:1:5 | ↑ | ↑ | 5330 | 3900 | 26.8 |
| 0.01 :1:5 | ↑ | ↑ | 4520 | 1930 | 57.3 |
| 0.05 :1:5 | ↑ | ↑ | 5610 | 1670 | 70.2 |
| 0.1 :1:5 | ↑ | ↑ | 5230 | 1100 | 79.0 |
| 0.5 :1:5 | ↑ | ↑ (0 ppm) | 5430 (7610) | 500 (4330) | 90.8 (43.1) |
| 1 :1:5 | ↑ | ↑ (0 ppm) | 5430 (5920) | 240 (1180) | 95.6 (80.1) |
| 2 :1:5 | ↑ | ↑ | 5240 | 210 | 96.0 |
| 5 :1:5 | ↑ | ↑ (0 ppm) | 5640 (8690) | 190 (3480) | 96.6 (60.0) |
| 10 :1:5 | ↑ | ↑ | 5540 | 210 | 96.2 |
| 15 :1:5 | ↑ | ↑ | 5580 | 1160 | 80.3 |

## Example 6

Wafers were cleaned in the same manner as in Example 1 except that a volume ratio of ammonia, aqueous hydrogen peroxide and ultra pure water was changed to 0.1:1:5 (NH$_4$OH:H$_2$O$_2$:H$_2$O), a surfactant shown in Table 6 was added, and the cleaning temperature was 25°C. The results are shown in Table 6.

For comparison, the results obtained by adding no surfactant, or a cationic or nonionic surfactant to dilute hydrofluoric acid are also shown in Table 6.

Table 6

| Surfactant added to NH$_4$OH-H$_2$O$_2$-H$_2$O mixture | | Surfactant added to 0.5 % hydrofluoric acid | | No. of particles adhered to wafer (No./wafer) | | Particle-removing rate (%) |
|---|---|---|---|---|---|---|
| Structure | Concentration | Structure | Concentration | Before cleaning | After cleaning | |
| (None) | 0 ppm | C$_9$F$_{17}$-O-p-Ph-SO$_3$H | 10 ppm | 5230 | 1100 | 79.0 |
| C$_9$F$_{17}$-O-p-Ph-SO$_3$H (anionic) | 50 ppm | ↑ | 10 ppm | 6530 | 250 | 96.2 |
| C$_{12}$H$_{25}$-Ph(SO$_3$H)-O-Ph(SO$_3$H) (anionic) | 50 ppm | ↑ | 10 ppm | 6470 | 450 | 93.0 |
| C$_7$F$_{15}$COONH$_4$ (anionic) | 200 ppm | ↑ | 10 ppm | 5740 | 570 | 90.1 |
| C$_{12}$H$_{25}$N(CH$_2$CH$_2$OH)$_2$ (cationic) | 200 ppm | ↑ | 10 ppm | 6480 | 3690 | 43.1 |
| C$_{12}$H$_{25}$O(CH$_2$CH$_2$O)$_9$H (nonionic) | 200 ppm | ↑ | 10 ppm | 5740 | 940 | 83.6 |

Example 7

Wafers were cleaned in the same manner as in Example 1 except that a volume ratio of ammonia, aqueous hydrogen peroxide and ultra pure water was changed to X:1:5 (NH$_4$OH:H$_2$O$_2$:H$_2$O) (X being shown in Table 7), and the cleaning temperature was 25°C. The results are shown in Table 7.

Table 7

| Surfactant added to NH$_4$OH-H$_2$O$_2$-H$_2$O mixture | | Surfactant added to 0.5 % hydrofluoric acid | | No. of particles adhered to wafer (No./wafer) | | Particle-removing rate (%) |
|---|---|---|---|---|---|---|
| Structure (mixing ratio) | Concentration | Structure | Concentration | Before cleaning | After cleaning | |
| C$_9$F$_{17}$-O-p-Ph-SO$_3$H (0.005:1:5) | 50 ppm | C$_9$F$_{17}$-O-p-Ph-SO$_3$H | 10 ppm | 6000 | 1680 | 72.0 |
| ↑ (0.1:1:5) | 50 ppm | ↑ | 10 ppm | 6530 | 250 | 96.2 |
| ↑ (0.5:1:5) | 50 ppm | ↑ | 10 ppm | 5660 | 170 | 97.0 |
| ↑ (1:1:5) | 50 ppm | ↑ | 10 ppm | 6550 | 200 | 96.9 |
| ↑ (2:1:5) | 500 ppm | ↑ | 10 ppm | 5670 | 360 | 93.7 |

**Claims**

1. A method for cleaning a substrate by the removal of deposited particles from the substrate, comprising the steps of:

   (1) cleaning the substrate with ammonia and aqueous hydrogen peroxide,
   (2) rinsing the substrate with ultra pure water,
   (3) cleaning the substrate with hydrofluoric acid containing an anionic surfactant,
   and
   (4) rinsing the substrate with ultra pure water.

2. The method according to claim 1, wherein a mixture containing ammonia and aqueous hydrogen peroxide further contains an anionic surfactant.

3. The method according to claim 1 or 2, wherein the concentration of said anionic surfactant in hydrofluoric acid or the mixture containing ammonia and aqueous hydrogen peroxide is at least 0.1 ppm.

4. The method according to any one of claims 1 to 3, wherein said anionic surfactant is at least one surfactant selected from the group consisting of carboxylic acid type, sulfonic acid type and sulfate type anionic surfactants having a hydrophilic group of the formula: -COOH, -SO$_3$H or -OSO$_3$H and their metal salts, ammonium salts, and primary, secondary and tertiary amine salts.

Fig. 1

Fig. 2

Fig. 3

| INTERNATIONAL SEARCH REPORT | International application No. |
|---|---|
| | PCT/JP96/00028 |

**A. CLASSIFICATION OF SUBJECT MATTER**

Int. Cl$^6$  H01L21/304

According to International Patent Classification (IPC) or to both national classification and IPC

**B. FIELDS SEARCHED**

Minimum documentation searched (classification system followed by classification symbols)

Int. Cl$^6$  H01L21/304

Documentation searched other than minimum documentation to the extent that such documents are included in the fields searched

| | |
|---|---|
| Jitsuyo Shinan Koho | 1964 – 1995 |
| Kokai Jitsuyo Shinan Koho | 1971 – 1993 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 6-177101, A (Mitsubishi Materials Corp.), June 24, 1994 (24. 06. 94), Claims 1 to 2 (Family: none) | 1 – 3 |
| Y | JP, 6-41770, A (Daikin Industries, Ltd.), February 15, 1994 (15. 02. 94), Claims 1 to 4 (Family: none) | 1 – 4 |
| Y | JP, 6-236867, A (Mitsubishi Materials Corp.), August 23, 1994 (23. 08. 94), Claims 1 to 2 (Family: none) | |

☐  Further documents are listed in the continuation of Box C.   ☐  See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| March 18, 1996 (18. 03. 96) | April 9, 1996 (09. 04. 96) |

| Name and mailing address of the ISA/ | Authorized officer |
|---|---|
| Japanese Patent Office | |
| Facsimile No. | Telephone No. |

Form PCT/ISA/210 (second sheet) (July 1992)